# EUROPEAN PATENT APPLICATION

(11) **EP 4 471 500 A1**
(43) Date of publication of application: **04.12.2024**
(21) Application number: 23176589.2
(22) Date of filing: 01.06.2023
(51) Int. Cl.: G03F 7/00, G03F 9/00, G02B 5/18, G02B 26/08, G02B 27/10

(54) **AN ILLUMINATION MODULE FOR A METROLOGY DEVICE**

(71) Applicant: ASML Netherlands B.V., 5500 AH Veldhoven (NL)
(72) Inventor: VAN VOORST, Peter, Danny, 5500 AH Veldhoven (NL); KROT, Yury, 5500 AH Veldhoven (NL); SONNEVELD, Jacob, 5500 AH Veldhoven (NL); VAN GREEVENBROEK, Hendrikus, Robertus, Marie, 5500AH Veldhoven (NL); EURLINGS, Markus Franciscus Antonius, 5500 AH Veldhoven (NL)
(74) Representative: ASML Netherlands B.V.

(57) **Abstract**

Disclosed is an illumination configuration module comprising: a radiation modulation device being operable to receive spectrally dispersed broadband input radiation on an active area and to selectively diffract a diffracted fraction of said spectrally dispersed broadband input radiation to obtain spectrally configured radiation comprising desired diffracted radiation and nuisance diffracted radiation; and at least one spectral filter operable to substantially block a spectral portion of said spectrally configured radiation, the spectral portion comprising said nuisance diffracted radiation.

## Description

### FIELD

The present invention relates to an illumination configuration module for configuring a beam of illumination, and in particular such an illumination configuration module in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. In many cases, not all the spectral and/or polarization components of the white light are used for a particular measurement. For example, it is often desirable to vary the spectral and/or polarization characteristics of the radiation for a particular measurement. This can be achieved by filtering and polarization switching. This, however, comes with a system throughput penalty, as switching the radiation properties using present methods incurs a significant switching time penalty.

It is desirable to improve the configurability of measurement radiation characteristics.

### SUMMARY

According to a first aspect of the invention, there is provided an illumination configuration module comprising: a radiation modulation device being operable to receive spectrally dispersed broadband input radiation on an active area and to selectively diffract a diffracted fraction of said spectrally dispersed broadband input radiation to obtain spectrally configured radiation comprising desired diffracted radiation and nuisance diffracted radiation; and at least one spectral filter operable to substantially block a spectral portion of said spectrally configured radiation, the spectral portion comprising said nuisance diffracted radiation.

According to a second aspect of the invention, there is provided a method of spectrally configuring broadband input radiation to obtain spectrally configured radiation, the method comprising: spectrally dispersing said broadband input radiation to obtain spectrally dispersed broadband input radiation; selectively diffracting said spectrally dispersed broadband input radiation, such that said spectrally configured radiation comprises a diffracted fraction of said spectrally dispersed broadband input radiation, the diffracted fraction comprising desired diffracted radiation and nuisance diffracted radiation; and spectrally filtering at least a portion of said spectrally configured radiation so as to substantially block a spectral portion of said spectrally configured radiation, the spectral portion comprising said nuisance diffracted radiation

Other aspects of the invention comprise one or more metrology devices comprising an illumination arrangement according the first aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5(a) comprises a schematic diagram of a dark field scatterometer for use in measuring targets according to embodiments of the invention using a first pair of illumination apertures;
- Figure 5(b) comprises a detail of diffraction spectrum of a target grating for a given direction of illumination;
- Figure 5(c) illustrates a second pair of illumination apertures providing further illumination modes in using the scatterometer for diffraction based overlay measurements;
- Figure 5(d) a third pair of illumination apertures combining the first and second pair of apertures;
- Figure 6 depicts a schematic overview of a level sensor apparatus which may comprise a radiation source according to embodiments of the invention;
- Figure 7 depicts a schematic overview of an alignment sensor apparatus which may comprise a radiation source according to embodiments of the invention;
- Figure 8(a) depicts schematically a grating light valve (GLV), illustrating its basic operation in a top view;
- Figure 8(b) depicts schematically a grating light valve (GLV), illustrating its basic operation in an end-on view in a first configuration;
- Figure 8(c) depicts schematically a grating light valve (GLV), illustrating its basic operation in an end-on view in a second configuration;
- Figure 9(a) depicts schematically a top view of a GLV based illumination configuration module in a zero order configuration;
- Figure 9(b) depicts schematically a side view of the GLV based illumination configuration module in the zero order configuration;
- Figure 10 depicts schematically a side view and top view of a GLV based illumination configuration module in a first order configuration;
- Figure 11 depicts a detail of a GLV device which schematically illustrates a problem resulting from using GLV based illumination configuration module in the first order configuration caused by gaps between the GLV ribbons;
- Figure 12 depicts schematically a side view and top view of a GLV based illumination configuration module according to an embodiment;
- Figure 13 illustrates the diffracted beam positions in a pupil plane of the illumination configuration module of Figure 12; and
- Figure 14 depicts a block diagram of a computer system for controlling a system and/or method as disclosed herein.

### DETAILED DESCRIPTION

In the present document, the terms "radiation" and "beam" are used to encompass all types of electromagnetic radiation, including one, some or all of: visible (e.g., 400nm-700nm) (near-) infrared radiation (700nm to 1000nm) ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

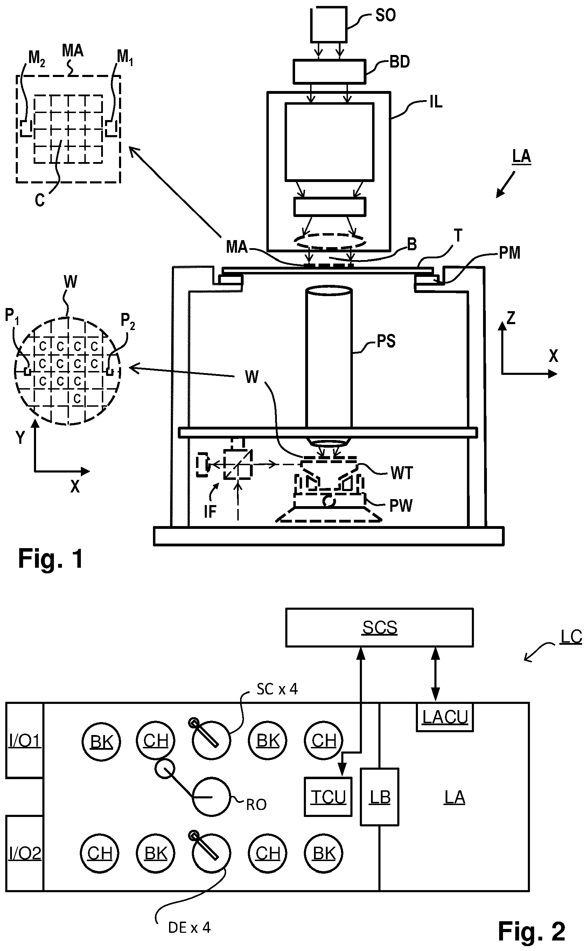

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

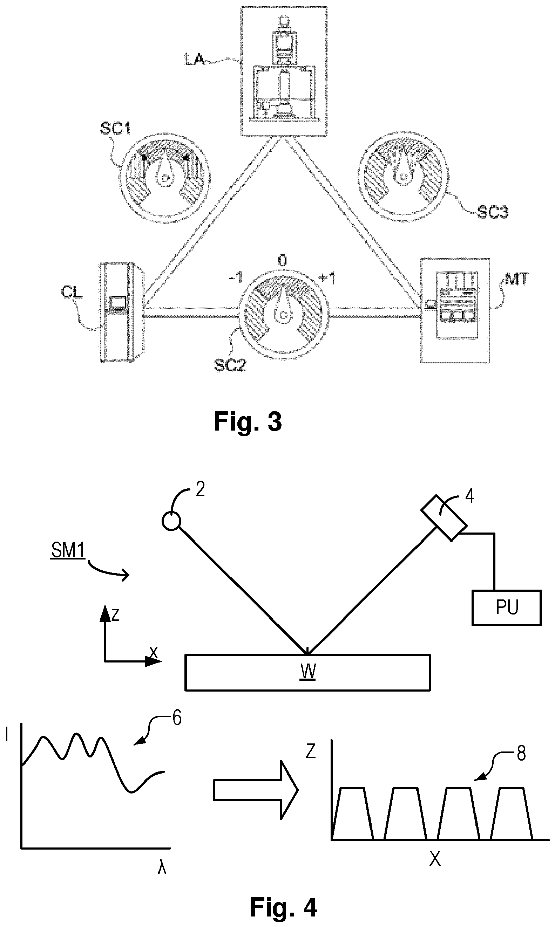

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1, incorporated herein by reference in its entirety.

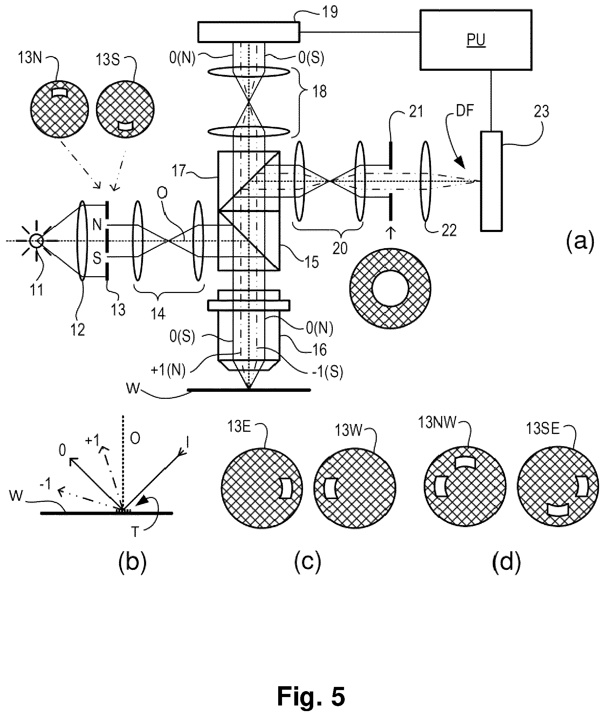

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

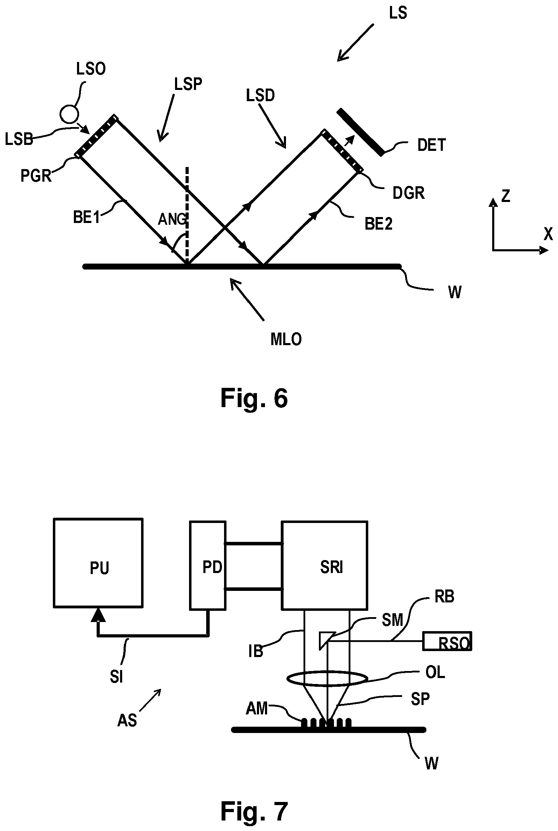

An example of a level or height sensor LS as known in the art is schematically shown in Figure 6, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 7 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies and/or polarization states to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

In many metrology applications, such as scatterometry or interferometry based metrology applications, e.g., for performance of pre-exposure metrology (such as alignment) or post-exposure metrology (e.g., overlay, CD, focus or other parameter of interest metrology), different information can be obtained from measurement of the same structure depending on the wavelength and polarization state of the measurement illumination used. For example, some present metrology systems provide measurement illumination configurable over multiple colors and three polarization settings (Horizontal, Vertical and both). However, the presently used illumination configuration modules (color switching modules) in such systems tend to be based on bulky mechanical modules which are slow. Additionally, such modules provide only three options when selecting the polarization of the incident beam: all wavelengths at a first polarization state (e.g., horizontal H), all wavelengths at a second polarization state (e.g., vertical V) or all wavelengths at both of these polarizations. It is very possible that any one polarization choice is suboptimal at some wavelengths. To measure each wavelength at its optimum polarization would require twice as many measurements as a single polarization measurement, with a slow polarization switch halfway through. Furthermore, arbitrary combinations of different polarization states are simply not presently possible.

A fast illumination configuration module or color switching module has been described, based on the grating light valve (GLV) concept. A GLV device disperses light (having been dispersed onto the GLV) such that the module can selectively remove or modulate light at one or more specific wavelengths. The resulting spectrum can be configured to comprise any desired shape, and can be varied at very high frequencies, possibly up to the MHz range. Such engineered spectra are a fast (microsecond switchable) way to extract a large amount of information from a target. However the known literature on GLV based illumination configuration describes only color selection, without any polarization selection functionality. Wavelength is only one degree of freedom. Polarization of the measurement illumination is another useful degree of freedom which may be exploited in metrology.

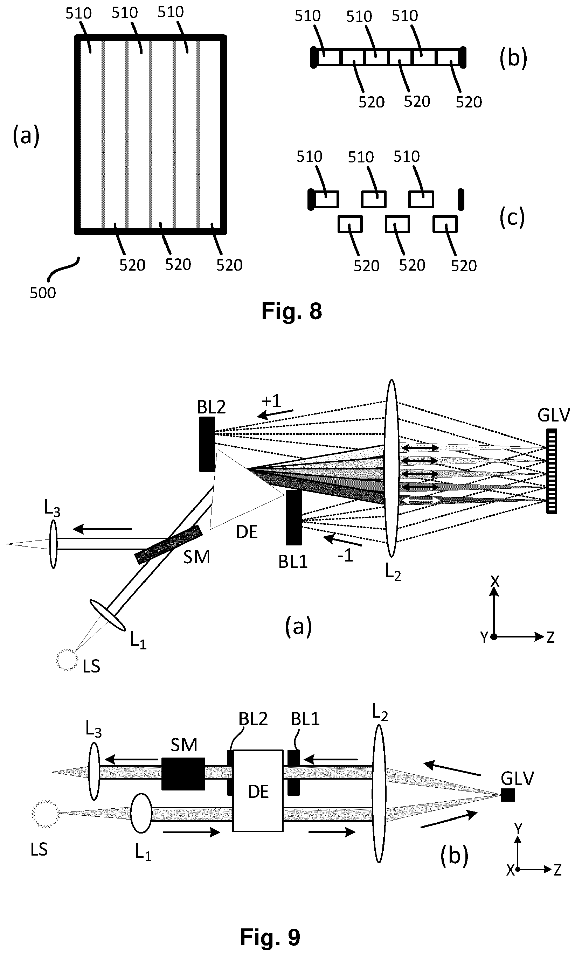

By way of example, and with reference to Figures 8 and 9, a GLV based illumination configuration module will now be described, configured to selectively transmit or block (diffract or reflect) at least part of incident broadband illumination. A GLV is an electrically-programmable diffraction grating based on Micro-Electro-Mechanical Systems (MEMS) technology. The GLV device may comprise configurable diffractive structures for selectively reflecting or diffracting the incident broadband illumination into an output radiation beam. Accordingly, output radiation illumination from such a module may comprise a spectrally configured beam having been modulated by the GLV device. A GLV device as used in embodiments disclosed herein may be a GLV device marketed by Silicon Light Machines (SLM), and/or based on GLV concept described in US6947613B, which is incorporated herein by reference.

Figures 8(a)-8(c) illustrate the working principal behind the GLV device. The GLV device may comprise an active area comprising alternating first reflective regions and second reflective regions, said first reflective regions (e.g., bias ribbons) and second reflective regions (e.g., active ribbons) comprising a configurable displacement between them, in a direction perpendicular to said active area, so as to selectively form a diffractive grating structure for selectively diffracting dispersed radiation incident on the active area.

Figures 8(a)-8(c) are schematic illustrations of a GLV pixel or component 500 from above and end-on, respectively. The GLV component comprises alternating GLV reflective ribbons of two types: static or bias ribbons 510 (more generally bias regions) which are typically grounded along with a common electrode, and driven or active ribbons 520 (more generally active regions) which are driven by an electronic driver channel. A GLV device may comprise any number of these GLV components 500 arranged in an array (e.g., a 1D or 2D array). The active and bias ribbons may be essentially identical other than in how they are driven.

In an embodiment, when no voltage is applied to the active ribbons 520, they are co-planar with the bias ribbons, a configuration illustrated in Figure 8(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 8(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

Figures 9(a) and 9(b) schematically illustrate a known illumination configuration module from two different viewpoints. A broadband input beam emitted from a broadband light source LS is dispersed in the X direction by a beam dispersion element DE, which may comprise, for example, a prism or a grating. The dispersion of the broadband input beam is achieved based on the principle that the direction of the light emerging from the beam dispersion element DE is wavelength dependent. The broadband input beam may be optionally collimated by a first optical lens L₁ before being dispersed by the beam dispersion element DE. The dispersed broadband input beam may then be focused (e.g., by a second optical lens L₂) onto the ribbons of the GLV device which is located substantially at the focal plane of the second lens L₂. The different shading is indicative of different wavelengths of the dispersed radiation.

In some embodiments, the GLV device may be operated in a wavelength selection mode to completely select one or more chosen wavelengths (e.g., without significant attenuation), and completely block the non-selected wavelengths. That is to say, the ribbons of the GLV device that correspond to the selected wavelengths may be set to equal heights such that they act like a standard mirror for the selected wavelengths and the other ribbons are actuated in such a way that they form a grating diffracting the undesired wavelengths into higher diffraction orders, e.g., -1^{st} and +1^{st} diffraction orders. These higher diffraction orders are then blocked or dumped by the beam blocks BL1, BL2, respectively. The GLV device may be operated also in intermediate modes or spectral shaping modes, e.g., to form a grating which partially reflects and partially diffracts the incident radiation for one or more wavelengths so as to attenuate but not completely block these one or more wavelengths. The degree of attenuation may be controlled via the ribbon configuration (the offset of the active ribbons with respect to the static ribbons). In this way, the spectral shape/constitution of the output radiation can be dynamically controlled.

The spatially modulated reflected (zeroth order) radiation from the GLV device may be captured by the second optical lens L₂. The spatially modulated optical beam is recombined on a return path, e.g., using the same dispersion element DE as was used to disperse the beam on the outward path (alternatively separate dispersion elements can be used for dispersing and combining). The return path within the dispersion element DE may be substantially parallel with and displaced in the Y direction with respect to the outward path. The recombined output illumination beam may then be directed by the steering mirror SM towards, for example, a third optical lens L₃. This third optical lens L₃ may act as an output lens so as to focus the output illumination beam into a metrology device; e.g., via a suitable optical fiber such as a single mode photonic crystal fiber.

Figure 9 illustrates the GLV device configured in a "zeroth order mode" such that it applies a certain spatial modulation to the focused broadband input beam so as to selectively reflect desired wavelengths and diffract away undesired wavelengths. Therefore, in such a configuration the diffracted radiation is blocked/dumped and the specularly reflected (zeroth diffraction order) radiation is selected (e.g., transmitted into an output illumination beam). In Figure 9, an aperture stop may be provided in a pupil plane with the aim of maximizing transmission of the zeroth order, and maximizing blocking (minimizing transmission) of the first orders (and other diffraction orders).

This zeroth order mode of operation has the advantage of preserving etendue, as the specularly reflected radiation will have no wavelength dependent output (reflection) angle. As such, it is fairly straight-forward to combine the selected wavelengths into a common path and preserve the small etendue required to couple the light into a (e.g., single mode) fiber.

A significant drawback of operating the GLV device in a zeroth order mode configuration such as described is that out-of-band suppression of the GLV device is insufficient for many applications, e.g., including being used as a radiation source in metrology tools such as those illustrated in Figures 4 to 7. With such a zeroth order mode configuration, there will always be a small but significant leakage of the unwanted color(s) into the output illumination beam. For example, when configured in a zeroth order mode it is very difficult, if not impossible, to reduce leakage to significantly below 0.1% (i.e., there will typically be at least 0.1 % of the incident radiation which is reflected from GLV regions configured to diffract/block all incident radiation on those regions). For metrology applications, this leakage should be at least one order of magnitude smaller, and preferably two to four orders of magnitude smaller.

Configuring the GLV ribbons to form a grating having a sufficiently high diffraction efficiency to achieve 0.01 % leakage or better is difficult or impossible because there will always be gaps between the ribbons, which results in light being reflected via these gaps. Furthermore, bending of the ribbons as they are displaced meaning that the correct (quarter-wavelength) displacement between the two sets of ribbons cannot be achieved over the whole GLV area relating to a blocked color.

To address this limited diffraction efficiency and therefore out-of-band suppression issue, the configuration illustrated in Figure 9 may be reversed such that the diffracted (first order) radiation is used and the specular, zeroth order radiation rejected; i.e., to configure the GLV device (or other radiation modulation device) in a "first order mode".

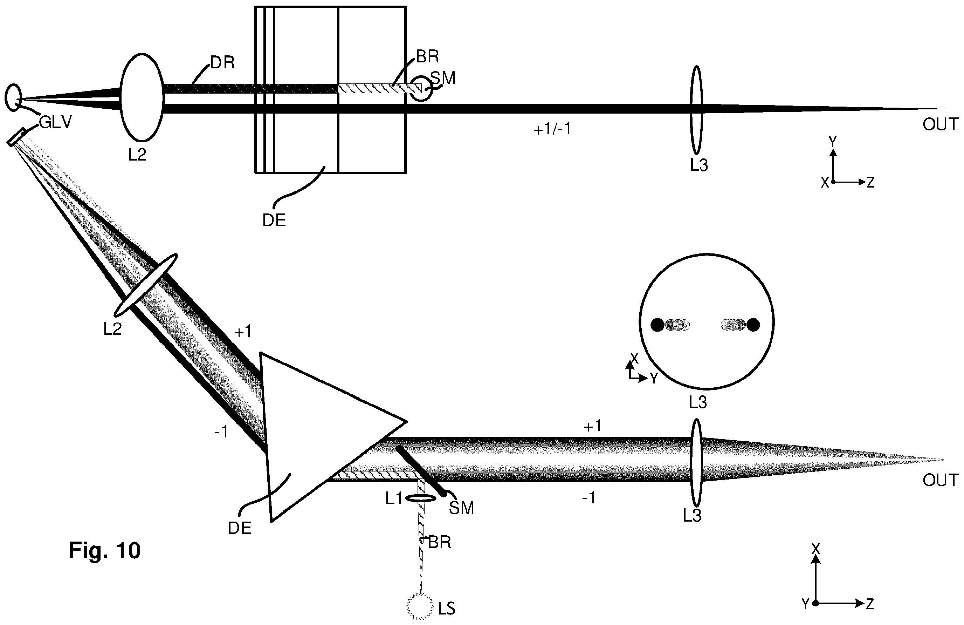

Figure 10 illustrates schematically an illumination configuration module comprising a GLV device configured for first-order mode operation in two views: top view (top) and side view (bottom). The arrangement is similar in many aspects to that illustrated in Figure 9 and these aspects will not necessarily be described again.

The broadband light source BR emits broadband radiation BR which is guided onto at least one dispersing element DE or prism (multiple dispersing elements/prisms may be used in an embodiment). The resultant dispersed radiation is focused (by lens L2) onto the GLV device. Note that the dispersed radiation DR on the outward path from dispersing element DE to GLV module is not shown on the side view diagram (bottom) for clarity reasons. The diffracted radiation (e.g., +1 and -1 diffracted orders) are captured by lens L2, propagate back through dispersing element DE, and are focused by lens L3 at an output OUT (e.g., into an optical fiber for admittance into a metrology tool). The zeroth order radiation from the GLV (not shown) is blocked, e.g. in any suitable manner between the GLV device and output OUT.

It may be appreciated that in such a first order mode of operation, etendue is no longer preserved. The outgoing radiation will now (per first order) comprise a wavelength dependent diffraction angle (output radiation direction). This can be appreciated by the inset of the beam positions on lens L3, e.g., where four individual colors are selected, represented by different grayscale shading, and the shading of the +1 and -1 beams. Note that on the GLV side of lens L3, the selected radiation is angularly resolved (e.g., a pupil plane; the term pupil plane herein referring to any angularly resolved plane where the selected radiation is angularly resolved, rather than anything more specific/limiting), such that beams scattered to different angles are at different locations in this plane.

In a first-order configuration, the diffraction efficiency becomes less critical; while some diffraction inefficiency may mean some (wanted) radiation loss, it does not affect out-of-bound suppression. For a particular region of the GLV active area configured for rejection/reflection, very little or no radiation incident on that region when it is configured to reflect away radiation, will be diffracted in the same direction(s) as the wanted first order(s). Because of this, out-of-bound suppression will be very good, at least over a portion of the active area relating to a sufficiently narrow spectral range. In this context, the GLV device active area may comprise the area defined by the GLV ribbons, and therefore the area responsible for receiving the dispersed broadband radiation and configuring its spectrum.

However, an issue arises when the spectral range of the dispersed radiation being spectrally configured by the GLV device has a spectral range sufficiently wide such that unwanted or nuisance diffraction from the gaps between the ribbons of the GLV device becomes a problem. These gaps result in an effective nuisance diffraction grating formed by the ribbons and gaps, which has a pitch which is half that of the GLV pitch (pitch of the GLV ribbons). Because of this half-pitch effective nuisance grating, any spectral range greater than a single octave will suffer from reduced out-of-band suppression. By way of a specific example, where a single wavelength λ (e.g., 800nm) is selected, and all others rejected, the nuisance grating will result in some leakage at wavelengths ½ λ (e.g., 400nm) and below into the collected radiation.

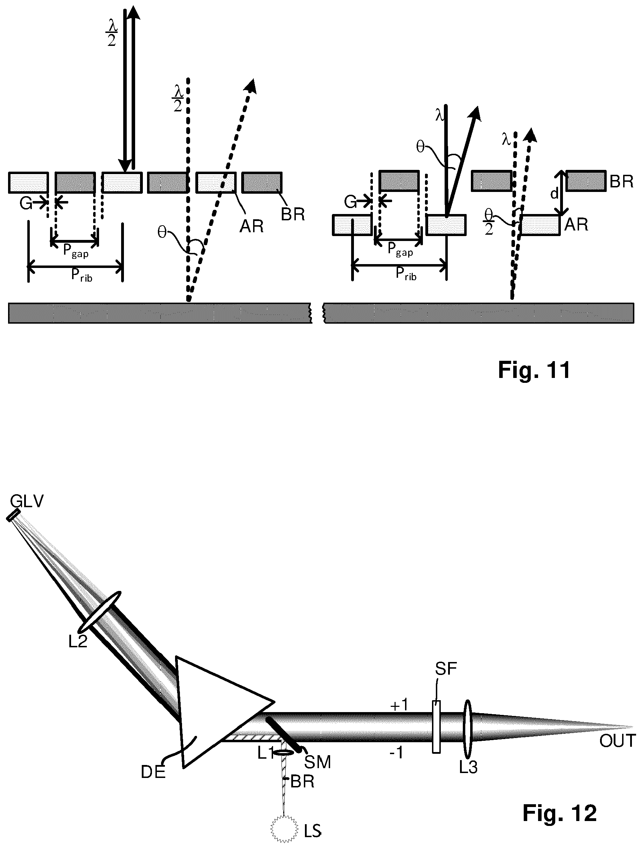

Figure 11 illustrates this issue with first-order mode configuration. The drawing shows a first region (left) of the active area configured to reject (i.e., reflect) the incident radiation thereon and a second region (right) of the active area configured to select (i.e., diffract) the incident radiation thereon. As such, the first region has the active ribbons AR substantially co-planar with the bias ribbons BR, and the second region has the active ribbons displaced to form a diffraction grating, e.g., by a distance d which may be a quarter of the incident wavelength in an embodiment. The second region receives incident radiation having a wavelength λ and the first region receives a wavelength half this wavelength ½λ. Note that these regions would be further apart than shown, with intervening wavelengths incident over the intervening section. The main GLV pitch (ribbon pitch) is P_{rib} and the nuisance grating (ribbon-gap pitch) is P_{gap}=½ P_{rib}.

The (majority of the) incident radiation (solid arrow at wavelength λ) on the second region is diffracted to an angle θ where it will be collected (e.g., by lens L2 as illustrated in Figure 10). Due to the gaps G, there may be some additional or secondary diffraction (dashed arrow at wavelength λ) at an angle θ/2, but as this is a selected wavelength, this is not a problem. The majority of the incident radiation (solid arrow at wavelength λ/2) on the first region is specularly reflected. However, there is a component (dashed arrow at wavelength λ/2) which will be diffracted by the gaps G to angle θ and therefore will contribute to out-of-band radiation captured by lens L2.

As has already been described, the main motivation for using the GLV device in first-order mode is to suppress out-of-band radiation in the output beam as much as possible. When the radiation comprises wavelengths of only a single octave or less, the nuisance diffraction can be removed spatially, e.g., by spatial filtering, as such nuisance diffraction will be diffracted to angles different from any of the wanted/selected wavelengths. However, this leakage is a major problem when the radiation being configured spectrally spans over an octave, and potentially negates the advantages of using the GLV device in a first-order configuration.

To address this issue, a GLV-based (or other radiation modulation device based) radiation modulation device is proposed comprising at least one spectral filter operable to substantially block a spectral portion (e.g., a range of wavelengths) of spectrally configured radiation, the spectrally configured radiation comprising a diffracted fraction of broadband input radiation subsequent to having been diffracted by an active area of a GLV device (i.e., operating in a first-order mode), the spectrally configured radiation comprising desired diffracted radiation and nuisance diffracted radiation, the spectral portion comprising said nuisance diffracted radiation. The at least one spectral filter may be configured such that substantially none of said desired diffracted radiation is blocked by said at least one spectral filter and therefore substantially all of said desired diffracted radiation is output from said illumination configuration module.

Substantially blocking may comprise blocking more than 95% or more than 99% of the nuisance diffracted radiation incident on the spectral filter. Substantially none of said desired diffracted radiation being blocked by said at least one spectral filter means that less than 10%, less than 5% or less than 1% of the desired diffracted radiation is blocked by said at least one spectral filter (substantially all of said desired diffracted radiation in this context may mean more than 90%, more than 95% or more than 99% of said desired diffracted radiation).

The diffracted fraction may comprise substantially all of the broadband input radiation or a smaller fraction thereof, depending on the GLV device configuration (i.e., "fraction" should be understood to encompass a substantially all of the input radiation, e.g., if all wavelengths are selected).

In an embodiment, the at least one spectral filter may comprise at least one high-pass cut-off wavelength for each octave (e.g., a range between a wavelength and half of that wavelength) of the broadband input illumination, the cut-off wavelength for each octave comprising a wavelength within said octave (e.g., where the octave spans 400nm to 800nm, the cut-off wavelength may be e.g., 700nm or 750nm.

The spectral filter may be configured to filter only a longer wavelength portion of each octave.

Each of said one or more filters may comprise a non-contiguous filter (e.g., physically separate portions), for example to filter respectively each diffraction order of a pair of complementary diffraction orders of the spectrally configured radiation (e.g., +1 and -1 orders).

Figure 12 is an example of such a radiation modulation device. The radiation modulation device comprises a spectral filter SF located in this example between dispersing element DE and the final lens L3. All else is the same as the arrangement illustrated in Figure 10 and will not be described further.

It should be appreciated that the location (in the Z-direction, e.g., along the optical axis) of the spectral filter SF in this drawing is only an example location, and the spatial filter may be located at any location after (downstream) of the GLV device and where the radiation is dispersed such that different wavelengths are (at least partially) spaced apart. As such, a spectral filter SF may be positioned at any pupil plane (angularly resolved plane) downstream from the GLV (e.g., anywhere between lens L2 and L3 in Figure 12, and therefore may be either side of the dispersing element DE). It is also possible to position a spectral filter SF between GLV and collecting lens L2 and/or between output lens L3 and output OUT; it can be appreciated that in such embodiments it may be better to locate the spectral filter closer to the lens rather than GLV device/output as the wavelengths will be better/more separated.

The spectral filter SF may comprise, for example, a single high pass filter (e.g., having a single cut-off wavelength). This may be suitable, for example, when the incident illumination to be configured spans less than 2 octaves (e.g., spans between 1 and 2 octaves). Where the incident illumination spans more than 2 octaves, then one or more high pass filters comprising a separate cut-off wavelength per octave may be provided.

The spectral filter should be positioned with respect to the spectrally configured illumination such that only nuisance radiation is blocked. In this respect, it is proposed to take advantage of the fact that different wavelengths are diffracted to different angles by the GLV device, assuming the same pitch. As such, for example, each region of a pupil plane (or any dispersed plane) downstream of the GLV device should correspond with a respective wavelength. Therefore any spectral filter configured for blocking nuisance diffracted radiation should be positioned to block only the nuisance diffracted radiation, and not to block any desired diffracted radiation of the same or similar wavelengths as the nuisance diffracted radiation.

By way of the specific example illustrated in Figure 11, a filter may be positioned at a location or each location (e.g., in the dispersal direction) in a pupil plane which corresponds with a diffraction angle of magnitude θ (or a diffraction angle subset represented by θ), the filter having an edge (high-pass) somewhere between λ/2 and λ. In this way, at this location of the pupil plane (i.e., for diffraction angle(s) of magnitude θ), nuisance diffracted radiation of wavelength λ/2 is blocked, but the desired diffracted radiation of wavelength λ is not blocked. However, this same filter (i.e., having the same edge position) should not extend to cover pupil plane location(s) corresponding to angle θ/2 (e.g., should not extend to block radiation having diffraction angle(s) of magnitude θ/2) as this is the angle to which the radiation of wavelength λ/2 will be diffracted, when selected by the GLV device (e.g., to ensure desired diffracted radiation of wavelength λ/2 is not blocked by the spectral filter).

As such, the spectral filter at each position in the pupil plane (or other spectrally dispersed plane downstream of the GLV) may comprise a high-pass (or suitable band-pass) filter with cut-off wavelength between λ/2 and λ where λ is the expected wavelength at that pupil plane location.

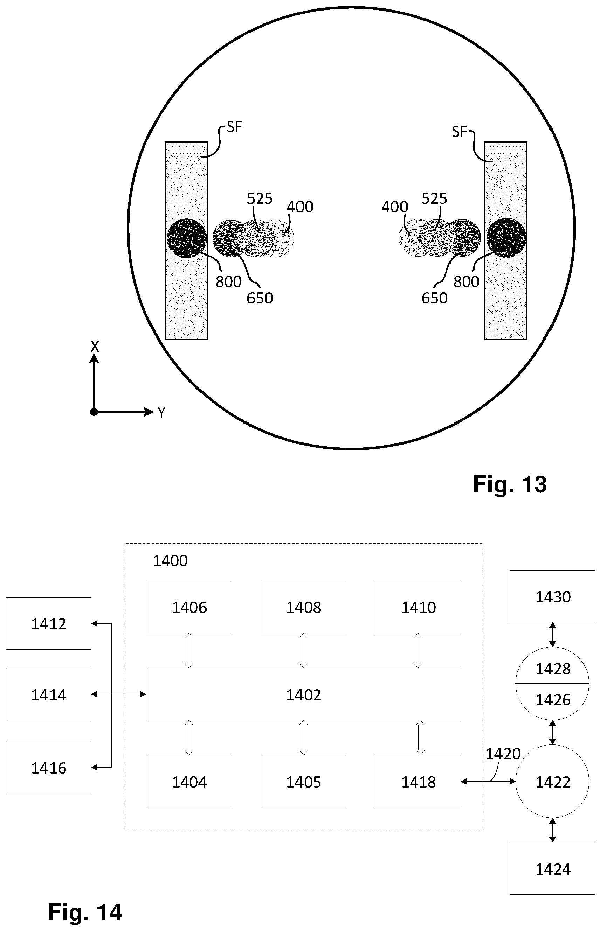

Figure 13 comprises a pupil plane representation downstream of the GLV device in such an embodiment. Shown are beam regions 400, 525, 650, 800 corresponding to four wavelengths, e.g., 400nm, 525nm, 650nm and 800nm respectively at their expected positions in the pupil plane. The at least one spectral filter SF is positioned in this specific example to filter the region 800 corresponding to the 800nm radiation, and may comprise a high-pass filter having a cut-off wavelength between 400nm and 800nm. This ensures that any 400nm nuisance radiation (not shown) diffracted to region 800 of the pupil plane is blocked by the spectral filter SF. However, the spectral filter SF does not filter the regions 400 corresponding to desired 400nm radiation (e.g., the expected diffraction positions for 400nm radiation).

In an embodiment, the spectral filter may comprise a continuously variable filter, e.g., a continuously variable edge filter or band-pass filter. Such a continuous variable spectral filter may be positioned in the path of the full range of expected diffraction angles, or only a diffraction angle subset, and have a cut-off frequency appropriate for the expected wavelength(s) at each filter portion (e.g., per octave). In other embodiments the spectral filter may comprise a non-continuously variable filter (i.e., a filter other than a continuously variable filter or wedge filter), e.g., one or more simple high-pass or band-pass filters.

The at least one spectral filter may comprise a separate or discrete filter element and/or it may comprise a filter coating on any other optical element in the path of the spectrally configured radiation, such as any of lenses L2, L3 and/or any one of the at least one dispersing element DE in Figure 12.

While the radiation modulation device is specifically described as a GLV device in the above description, any suitable radiation modulation device which selectively diffracts spectrally dispersed incident radiation into spectrally configured radiation can be used.

Figure 14 is a block diagram that illustrates a computer system 1400 that may assist in implementing the methods and flows disclosed herein. Computer system 1400 includes a bus 1402 or other communication mechanism for communicating information, and a processor 1404 (or multiple processors 1404 and 1405) coupled with bus 1402 for processing information. Computer system 1400 also includes a main memory 1406, such as a random access memory (RAM) or other dynamic storage device, coupled to bus 1402 for storing information and instructions to be executed by processor 1404. Main memory 1406 also may be used for storing temporary variables or other intermediate information during execution of instructions to be executed by processor 1404. Computer system 1400 further includes a read only memory (ROM) 1408 or other static storage device coupled to bus 1402 for storing static information and instructions for processor 1404. A storage device 1410, such as a magnetic disk or optical disk, is provided and coupled to bus 1402 for storing information and instructions.

Computer system 1400 may be coupled via bus 1402 to a display 1412, such as a cathode ray tube (CRT) or flat panel or touch panel display for displaying information to a computer user. An input device 1414, including alphanumeric and other keys, is coupled to bus 1402 for communicating information and command selections to processor 1404. Another type of user input device is cursor control 1416, such as a mouse, a trackball, or cursor direction keys for communicating direction information and command selections to processor 1404 and for controlling cursor movement on display 1412. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1400 in response to processor 1404 executing one or more sequences of one or more instructions contained in main memory 1406. Such instructions may be read into main memory 1406 from another computer-readable medium, such as storage device 1410. Execution of the sequences of instructions contained in main memory 1406 causes processor 1404 to perform the process steps described herein. One or more processors in a multi-processing arrangement may also be employed to execute the sequences of instructions contained in main memory 1406. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1404 for execution. Such a medium may take many forms, including but not limited to, non-volatile media, volatile media, and transmission media. Non-volatile media include, for example, optical or magnetic disks, such as storage device 1410. Volatile media include dynamic memory, such as main memory 1406. Transmission media include coaxial cables, copper wire and fiber optics, including the wires that comprise bus 1402. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1404 for execution. For example, the instructions may initially be borne on a magnetic disk of a remote computer. The remote computer can load the instructions into its dynamic memory and send the instructions over a telephone line using a modem. A modem local to computer system 1400 can receive the data on the telephone line and use an infrared transmitter to convert the data to an infrared signal. An infrared detector coupled to bus 1402 can receive the data carried in the infrared signal and place the data on bus 1402. Bus 1402 carries the data to main memory 1406, from which processor 1404 retrieves and executes the instructions. The instructions received by main memory 1406 may optionally be stored on storage device 1410 either before or after execution by processor 1404.

Computer system 1400 also preferably includes a communication interface 1418 coupled to bus 1402. Communication interface 1418 provides a two-way data communication coupling to a network link 1420 that is connected to a local network 1422. For example, communication interface 1418 may be an integrated services digital network (ISDN) card or a modem to provide a data communication connection to a corresponding type of telephone line. As another example, communication interface 1418 may be a local area network (LAN) card to provide a data communication connection to a compatible LAN. Wireless links may also be implemented. In any such implementation, communication interface 1418 sends and receives electrical, electromagnetic or optical signals that carry digital data streams representing various types of information.

Network link 1420 typically provides data communication through one or more networks to other data devices. For example, network link 1420 may provide a connection through local network 1422 to a host computer 1424 or to data equipment operated by an Internet Service Provider (ISP) 1426. ISP 1426 in turn provides data communication services through the worldwide packet data communication network, now commonly referred to as the "Internet" 1428. Local network 1422 and Internet 1428 both use electrical, electromagnetic or optical signals that carry digital data streams. The signals through the various networks and the signals on network link 1420 and through communication interface 1418, which carry the digital data to and from computer system 1400, are exemplary forms of carrier waves transporting the information.

Computer system 1400 may send messages and receive data, including program code, through the network(s), network link 1420, and communication interface 1418. In the Internet example, a server 1430 might transmit a requested code for an application program through Internet 1428, ISP 1426, local network 1422 and communication interface 1418. One such downloaded application may provide for one or more of the techniques described herein, for example. The received code may be executed by processor 1404 as it is received, and/or stored in storage device 1410, or other non-volatile storage for later execution. In this manner, computer system 1400 may obtain application code in the form of a carrier wave.

Additional embodiments are disclosed in the subsequent list of numbered clauses:
1. An illumination configuration module comprising:
   a radiation modulation device being operable to receive spectrally dispersed broadband input radiation on an active area and to selectively diffract a diffracted fraction of said spectrally dispersed broadband input radiation to obtain spectrally configured radiation comprising desired diffracted radiation and nuisance diffracted radiation; and
   at least one spectral filter operable to substantially block a spectral portion of said spectrally configured radiation, the spectral portion comprising said nuisance diffracted radiation.
2. An illumination configuration module as defined in clause 1, wherein the radiation modulation device comprises a grating light valve device.
3. An illumination configuration module as defined in clause 1 or 2, wherein the at least one spectral filter is configured such that substantially none of said desired diffracted radiation is blocked by said at least one spectral filter.
4. An illumination configuration module as defined in any preceding clause, wherein the at least one spectral filter is located downstream of the radiation modulation device where the spectrally configured radiation is spectrally dispersed.
5. An illumination configuration module as defined in any preceding clause, wherein the at least one spectral filter comprises at least one high-pass cut-off wavelength for each octave of the broadband input illumination, the cut-off wavelength for each octave comprising a wavelength within said octave.
6. An illumination configuration module as defined in clause 5, wherein the at least one spectral filter is configured to filter only an upper portion of each octave, comprising longer wavelengths.
7. An illumination configuration module as defined in clause 5 or 6, wherein the at least one spectral filter is located in an angularly resolved plane of the illumination configuration module.
8. An illumination configuration module as defined in clause 7, wherein the at least one spectral filter is located to filter regions of said angularly resolved plane corresponding to diffraction angles of said spectrally configured radiation corresponding to an upper portion of each octave, comprising longer wavelengths.
9 An illumination configuration module as defined in any preceding clause, wherein the at least one spectral filter comprises a continuous variable spectral filter.
10. An illumination configuration module as defined in any of clauses 1 to 8, wherein the at least one spectral filter comprises a non-continuous variable spectral filter.
11. An illumination configuration module as defined in clause 10, wherein the at least one spectral filter comprises one or more high-pass filters and/or band-pass filters.
12. An illumination configuration module as defined in any preceding clause, wherein said at least one spectral filter comprises a non-contiguous filter to filter respectively each diffraction order of a pair of complementary diffraction orders of the spectrally configured radiation.
13. An illumination configuration module as defined in any preceding clause, wherein one or more of said at least one spectral filter comprises a discrete filter.
14. An illumination configuration module as defined in any preceding clause, wherein one or more of said at least one spectral filter comprises a filter coating on an optical element of the illumination configuration module.
15. An illumination configuration module as defined in any preceding clause, further comprising a beam dispersion element operable to receive and spectrally disperse said broadband input radiation to obtain said spectrally dispersed broadband radiation.
16. An illumination configuration module as defined in any preceding clause, further comprising a broadband radiation source operable to provide said broadband input radiation.
17. An illumination configuration module as defined in any preceding clause, wherein said broadband input radiation spans over an octave.
18. A method of spectrally configuring broadband input radiation to obtain spectrally configured radiation, the method comprising:
   spectrally dispersing said broadband input radiation to obtain spectrally dispersed broadband input radiation;
   selectively diffracting said spectrally dispersed broadband input radiation, such that said spectrally configured radiation comprises a diffracted fraction of said spectrally dispersed broadband input radiation, the diffracted fraction comprising desired diffracted radiation and nuisance diffracted radiation; and
   spectrally filtering at least a portion of said spectrally configured radiation so as to substantially block a spectral portion of said spectrally configured radiation, the spectral portion comprising said nuisance diffracted radiation.
19. A method as defined in clause 18, wherein said spectrally filtering substantially blocks none of said desired diffracted radiation.
20. A method as defined in clause 18 or 19, wherein said spectrally filtering is performed downstream of the radiation modulation device where the spectrally configured radiation is spectrally dispersed.
21. A method as defined in clause 18, 19 or 20, wherein said spectrally filtering comprises at least one high-pass cut-off wavelength for each octave of the broadband input illumination, the cut-off wavelength for each octave comprising a wavelength within said octave.
22. A method as defined in clause 21, wherein said spectrally filtering filters only an upper portion of each octave, comprising longer wavelengths.
23. A method as defined in clause 21 or 22, wherein said spectrally filtering is performed in an angularly resolved plane.
24. A method as defined in clause 23, wherein said spectrally filtering is performed at regions of said angularly resolved plane corresponding to diffraction angles of said spectrally configured radiation corresponding to an upper portion of each octave, comprising longer wavelengths.
25. A method as defined in clause 24, wherein no spectral filtering is performed outside of said regions of said angularly resolved plane corresponding to diffraction angles of said spectrally configured radiation corresponding to an upper portion of each octave.
26. A method as defined in any of clauses 18 to 25, wherein said spectrally filtering comprises applying a continuously variable filter.
27. A metrology device comprising an illumination configuration module as defined in any of clauses 1 to 17, operable to use said spectrally configured radiation as measurement illumination for a measurement.
28. A metrology device as defined in clause 27, wherein the metrology device comprises a scatterometer, interferometer or holographic microscope.
29. A metrology device as defined in clause 28, wherein the metrology device comprises an alignment sensor or level sensor.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination configuration module comprising:
a radiation modulation device being operable to receive spectrally dispersed broadband input radiation on an active area and to selectively diffract a diffracted fraction of said spectrally dispersed broadband input radiation to obtain spectrally configured radiation comprising desired diffracted radiation and nuisance diffracted radiation; and
at least one spectral filter operable to substantially block a spectral portion of said spectrally configured radiation, the spectral portion comprising said nuisance diffracted radiation.

2. An illumination configuration module as claimed in claim 1, wherein the radiation modulation device comprises a grating light valve device.

3. An illumination configuration module as claimed in claim 1 or 2, wherein the at least one spectral filter is configured such that substantially none of said desired diffracted radiation is blocked by said at least one spectral filter.

4. An illumination configuration module as claimed in any preceding claim, wherein the at least one spectral filter is located downstream of the radiation modulation device where the spectrally configured radiation is spectrally dispersed.

5. An illumination configuration module as claimed in any preceding claim, wherein the at least one spectral filter comprises at least one high-pass cut-off wavelength for each octave of the broadband input illumination, the cut-off wavelength for each octave comprising a wavelength within said octave.

6. An illumination configuration module as claimed in claim 5, wherein the at least one spectral filter is configured to filter only an upper portion of each octave, comprising longer wavelengths.

7. An illumination configuration module as claimed in claim 5 or 6, wherein the at least one spectral filter is located in an angularly resolved plane of the illumination configuration module.

8. An illumination configuration module as claimed in claim 7, wherein the at least one spectral filter is located to filter regions of said angularly resolved plane corresponding to diffraction angles of said spectrally configured radiation corresponding to an upper portion of each octave, comprising longer wavelengths.

9. An illumination configuration module as claimed in any preceding claim, wherein the at least one spectral filter comprises a continuous variable spectral filter.

10. An illumination configuration module as claimed in any of claims 1 to 8, wherein the at least one spectral filter comprises a non-continuous variable spectral filter.

11. An illumination configuration module as claimed in any preceding claim, wherein said at least one spectral filter comprises a non-contiguous filter to filter respectively each diffraction order of a pair of complementary diffraction orders of the spectrally configured radiation.

12. An illumination configuration module as claimed in any preceding claim, wherein one or more of said at least one spectral filter comprises a discrete filter.

13. An illumination configuration module as claimed in any preceding claim, wherein one or more of said at least one spectral filter comprises a filter coating on an optical element of the illumination configuration module.

14. A method of spectrally configuring broadband input radiation to obtain spectrally configured radiation, the method comprising:
spectrally dispersing said broadband input radiation to obtain spectrally dispersed broadband input radiation;
selectively diffracting said spectrally dispersed broadband input radiation, such that said spectrally configured radiation comprises a diffracted fraction of said spectrally dispersed broadband input radiation, the diffracted fraction comprising desired diffracted radiation and nuisance diffracted radiation; and
spectrally filtering at least a portion of said spectrally configured radiation so as to substantially block a spectral portion of said spectrally configured radiation, the spectral portion comprising said nuisance diffracted radiation.

15. A metrology device comprising an illumination configuration module as claimed in any of claims 1 to 13, operable to use said spectrally configured radiation as measurement illumination for a measurement.
